(19) Europäisches Patentamt / European Patent Office / Office européen des brevets

(11) **EP 4 339 661 B1**

(12) **EUROPEAN PATENT SPECIFICATION**

(45) Date of publication and mention
of the grant of the patent:
**01.04.2026 Bulletin 2026/14**

(21) Application number: **22807739.2**

(22) Date of filing: **09.05.2022**

(51) International Patent Classification (IPC):
*C09K 11/02* (2006.01)   *C09K 11/80* (2006.01)
*C03C 3/097* (2006.01)   *C03C 14/00* (2006.01)
*G02B 5/02* (2006.01)   *H10H 20/851* (2025.01)
*H10H 20/80* (2025.01)

(52) Cooperative Patent Classification (CPC):
**H10H 20/8511; C03C 3/097; C03C 14/004;
C03C 14/006; C09K 11/02; C09K 11/7774;
G02B 5/0242;** C03C 2214/04; C03C 2214/16;
H10H 20/882

(86) International application number:
**PCT/KR2022/006559**

(87) International publication number:
**WO 2022/240091 (17.11.2022 Gazette 2022/46)**

(54) **WAVELENGTH CONVERSION MEMBER AND LIGHT-EMITTING APPARATUS**

WELLENLÄNGENUMWANDLUNGSELEMENT UND LICHTEMITTIERENDE VORRICHTUNG

ÉLÉMENT DE CONVERSION DE LONGUEUR D'ONDE ET APPAREIL ÉLECTROLUMINESCENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.05.2021 KR 20210060656**

(43) Date of publication of application:
**20.03.2024 Bulletin 2024/12**

(73) Proprietor: **Daejoo Electronic Materials Co., Ltd.
Siheung-si, Gyeonggi-do 15094 (KR)**

(72) Inventors:
• **KIM, Yeon
Siheung-si, Gyeonggi-do 15094 (KR)**
• **LEE, Jung Kyu
Siheung-si, Gyeonggi-do 15094 (KR)**

• **CHANG, Soon Uk
Siheung-si, Gyeonggi-do 15094 (KR)**
• **JANG, Jae Won
Siheung-si, Gyeonggi-do 15094 (KR)**
• **LIM, Joong Kyu
Siheung-si, Gyeonggi-do 15094 (KR)**

(74) Representative: **HGF
HGF Limited
4th Floor, 1 City Square
Leeds LS1 2ES (GB)**

(56) References cited:
**WO-A1-2020/137780     WO-A1-2020/184562
JP-A- 2015 147 705     KR-A- 20150 092 213
KR-A- 20160 097 152     KR-B1- 101 588 220**

EP 4 339 661 B1

## Description

### Technical Field

The present invention relates to a wavelength conversion member and a light emitting device comprising the same. More specifically, it relates to a wavelength conversion member comprising spherical silica filler powder having a particle size distribution in a specific range and a light emitting device comprising the same.

### Background Art

In recent years, there has been growing interest in light emitting devices using excitation light sources such as light emitting diodes (LEDs) as a next-generation light emitting device from the viewpoints of low power, lightweight, and easy control of light quantity.

Such light emitting devices commonly comprise blue LEDs and a wavelength conversion member that absorbs blue light emitted from the blue LEDs and produces white light through yellow, green, or red light. The wavelength conversion member commonly has a structure in which phosphor powder is dispersed in an organic or inorganic matrix.

Specifically, a wavelength conversion member in which phosphor powder is dispersed in a resin matrix has been used. However, the above wavelength conversion member has a problem in that the resin deteriorates due to heat from the excitation light source or irradiated light, or the luminance of the light emitting device decreases.

Meanwhile, Japanese Laid-open Patent Publication No. 2003-258308 and Japanese Patent No. 4895541 disclose a method of preparing a wavelength conversion member in which phosphor powder is dispersed in a glass matrix. However, when a glass matrix is used, there is a problem in that some phosphors may deteriorate due to the high sintering temperature during the preparation of the wavelength conversion member, which may cause deterioration of optical characteristics and discoloration, and it is difficult to implement a wavelength conversion member with high color rendering due to limitations in the use of phosphors.

In addition, in such a wavelength conversion member, the excitation light of LEDs may not be sufficiently scattered inside the wavelength conversion member. In such a case, there is a problem in that the light emitted from the light emitting device is not uniform, and the fluorescence intensity decreases.

To solve this problem, methods of increasing the content of phosphor powder have been studied. In such a case, however, the amount of light scattered inside the wavelength conversion member can be increased, whereas the color deviation is large, and there is a limit to producing satisfactory colors.

[Prior art documents]

[Patent documents]

(Patent Document 1) Japanese Laid-open Patent Publication No. 2003-258308
(Patent Document 2) Japanese Patent No. 4895541

### Disclosure of Invention

### Technical Problem

The present invention is devised to solve the above problems of the prior art. A technical problem to be solved by the present invention is to provide a wavelength conversion member that has high fluorescence intensity and excellent optical properties. Especially, it can suppress a decrease in luminescence intensity over time when irradiated with high-output excitation light, and a process for preparing the same.

In addition, another technical problem to be solved by the present invention is to provide a light emitting device comprising the wavelength conversion member.

### Solution to Problem

The present invention provides a wavelength conversion member, which comprises a glass matrix; and phosphor powder and spherical silica filler powder dispersed in the glass matrix, wherein, when the particle sizes representing 10%, 50%, and 90% of the cumulative volume (%) in a particle size distribution measured by laser diffraction are D10, D50, and D90, respectively, D50 of the spherical silica filler powder is 1.0 to 15.0 $\mu$m, and the SPAN value of the following Equation 1 is 1.0 to 5.0.

[Equation 1]

$$SPAN = (D90 - D10)/D50$$

In addition, the present invention provides a process for preparing a wavelength conversion member, which comprises a first step of obtaining a composition for a wavelength conversion member comprising glass powder, phosphor powder, and spherical silica filler powder; a second step of applying the composition for a wavelength conversion member onto a substrate to obtain a green sheet for a wavelength conversion member; and a third step of sintering the green sheet for a wavelength conversion member.

Further, the present invention provides a light emitting device, which comprises the wavelength conversion member; and a light source that irradiates excitation light to the wavelength conversion member.

## Advantageous Effects of Invention

The wavelength conversion member of the present invention has high fluorescence intensity and excellent optical properties such as light transmittance, luminous flux, and converted luminous flux, and it can suppress a decrease in luminescence intensity over time when irradiated with high-output excitation light. Thus, it can be advantageously used in a light emitting device.

## Brief Description of Drawings

Hereinafter, the present invention will be described in more detail with reference to the drawing.

Fig. 1 schematically shows a plan view of a wavelength conversion member according to an embodiment of the present invention.

Fig. 2 illustrates a method of measuring the major axis and minor axis diameters of spherical silica filler powder according to an embodiment of the present invention.

Fig. 3 is a process flow chart showing a method of preparing a wavelength conversion member according to an embodiment of the present invention.

## Best Mode for Carrying out the Invention

The present invention is not limited to what is disclosed below. Rather, it may be modified in various forms as long as the gist of the invention is not altered.

In this specification, when a part is referred to as "comprising" an element, it is to be understood that the part may comprise other elements as well, unless otherwise indicated.

In this specification, singular expressions are interpreted to cover singular or plural as interpreted in context, unless otherwise specified.

In addition, all numbers and expressions related to the quantities of components, reaction conditions, and the like used herein are to be understood as being modified by the term "about" unless otherwise indicated.

In addition, in the present specification, in the case where a part such as a layer or a film is mentioned to be formed "on" another element, it covers not only that one element is directly formed "on" another element, but also that other element(s) is interposed between them.

In addition, the size of each component in the drawings may be exaggerated for explanation and does not mean the actual size. In addition, the same reference numerals refer to the same elements throughout the specification.

## [Wavelength conversion member]

The wavelength conversion member according to an embodiment of the present invention comprises a glass matrix; and phosphor powder and spherical silica filler powder dispersed in the glass matrix, wherein, when the particle sizes representing 10%, 50%, and 90% of the cumulative volume (%) in a particle size distribution measured by laser diffraction are D10, D50, and D90, respectively, D50 of the spherical silica filler powder is 1.0 to 15.0 $\mu$m, and the SPAN value of the following Equation 1 is 1.0 to 5.0.

[Equation 1]

$$SPAN = (D90 - D10)/D50$$

The wavelength conversion member according to an embodiment of the present invention comprises a glass matrix; and phosphor powder and spherical silica filler powder dispersed in the glass matrix. In particular, as the spherical silica filler powder has D50 and SPAN values in specific ranges, it has high fluorescence intensity and excellent optical properties. Especially, it can suppress a decrease in luminescence intensity over time when irradiated with high-output excitation light.

In addition, since the spherical silica filler powder has a high melting point of 1,400°C or higher, it has thermal resistance to the sintering temperature during the preparation of the wavelength conversion member to be chemically stable and is easily adsorbed to the phosphor. Thus, in the preparation of a wavelength conversion member, shrinkage of the wavelength conversion member that occurs during sintering can be suppressed, and uniform dispersion of phosphor particles within the wavelength conversion member can be maintained well.

Hereinafter, each component of the wavelength conversion member will be described in detail.

Glass matrix

The wavelength conversion member according to an embodiment of the present invention comprises a glass matrix. The glass matrix may be a base material for a wavelength conversion member obtained by molding and sintering glass powder as a raw material. Phosphor powder and spherical silica filler powder may be dispersed and contained in such a glass matrix.

Specifically, the glass matrix may be obtained by applying a composition for a wavelength conversion member comprising glass powder, phosphor powder, and spherical silica filler powder onto a substrate to a sheet shape and sintering the composition. In addition, the glass matrix may be obtained by putting phosphor powder, spherical silica filler powder, and glass powder into a mold, compression-molding the mixture, and then sintering it at, for example, 450 to 950°C.

The glass matrix may serve as a medium for stably maintaining the phosphor powder and spherical silica filler powder in a uniformly dispersed state in the glass matrix.

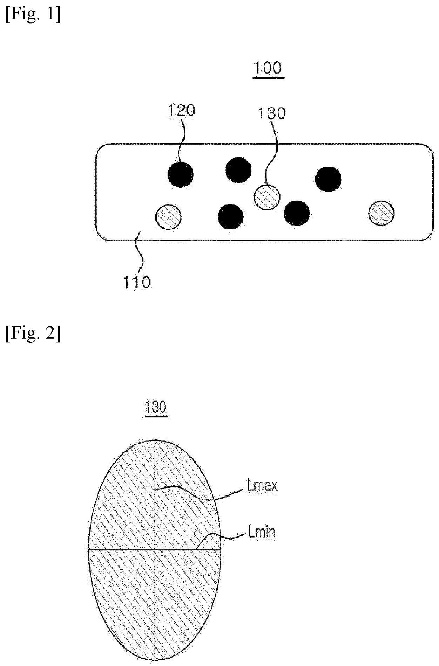

Referring to Fig. 1, in the wavelength conversion member (100) according to an embodiment of the present invention, phosphor powder (120) and spherical silica filler powder (130) may be uniformly dispersed in a glass matrix (110).

In addition, since there may be differences in reactivity between glass powder and phosphor powder depending on the composition of the glass powder as a raw material forming the glass matrix, it is important to select a composition of the glass powder suitable for the phosphor powder to be used. For example, if the sintering temperature is raised in the preparation of the wavelength conversion member, there may be a concern that the glass matrix and the phosphor will react, thereby decreasing the quantum conversion yield of the wavelength conversion member. Thus, the composition of the glass powder is important to prevent this.

According to an embodiment of the present invention, the glass matrix preferably comprises $P_2O_5$, ZnO, $SiO_2$, and $B_2O_3$ as main components.

Specifically, the glass matrix may be derived from glass powder with a specific composition.

The glass powder may comprise 2 to 10% by mole of $P_2O_5$, 30 to 50% by mole of ZnO, 10 to 25% by mole of $SiO_2$, and 15 to 25% by mole of $B_2O_3$ based on the total number of moles of the glass powder.

As the glass powder has the above composition, the glass powder can be sufficiently sintered even when the content of phosphor powder is large, and it is possible to suppress a decrease in luminance of light even when the wavelength conversion member is used for a long period of time. In addition, the wavelength conversion member has excellent water resistance even in humid environments, whereby it can achieve excellent light absorption.

Specifically, $P_2O_5$ is a component that forms a glass skeleton and enhances water resistance. The content of $P_2O_5$ may be 2 to 10% by mole, preferably 2 to 6% by mole, based on the total number of moles of the glass powder.

If the content of $P_2O_5$ is less than the above range, it may be difficult to vitrify. If it exceeds the above range, the softening point (Ts) may increase, and weather resistance may decrease.

ZnO is a component that improves solubility by lowering the melting temperature. The content of ZnO may be 30 to 50% by mole, preferably 30 to 40% by mole, based on the total number of moles of the glass powder.

If the content of ZnO is less than the above range, the effect of improving meltability may be insignificant. If it exceeds the above range, weather resistance may decrease, and transmittance may deteriorate to decrease luminescence intensity.

$SiO_2$ is a component that forms a glass skeleton. The content of $SiO_2$ may be 10 to 25% by mole, preferably 15 to 25% by mole.

If the content of $SiO_2$ is less than the above range, weather resistance and mechanical strength may deteriorate. If it exceeds the above range, the phosphor powder may be degraded due to sintering at high temperatures in the preparation of the wavelength conversion member.

$B_2O_3$ is a component that forms a glass skeleton. It can lower melting temperature, thereby improving meltability, and can enhance light diffusion. The content of $B_2O_3$ may be 15 to 25% by mole, preferably 15 to 20% by mole, based on the total number of moles of the glass powder.

If the content of $B_2O_3$ is less than the above range, there may be difficulty in achieving the above effect. If it exceeds the above range, chemical durability may decrease.

In addition, according to an embodiment of the present invention, the glass powder may further comprise at least one selected from the group consisting of 1 to 10% by mole of $Al_2O_3$, 0.1 to 7% by mole of $SnO_2$, 1 to 5% by mole of BaO, 0.1 to 5% by mole of SrO, 1 to 5% by mole of CaO, 1 to 5% by mole of $Li_2O$, 1 to 7% by mole of $Na_2O$, and 1 to 5% by mole of $K_2O$.

$Al_2O_3$ is a component that enhances chemical durability. The content of $Al_2O_3$ may be 1 to 10% by mole, preferably 2 to 6% by mole, based on the total number of moles of the glass powder.

If the content of $Al_2O_3$ is less than the above range, the effect of enhancing chemical durability may be insignificant. If the content of $Al_2O_3$ exceeds the above range, the meltability of glass may tend to deteriorate.

$SnO_2$ is a component that can lower the physical property temperatures concerning heat (thermophysical temperatures) such as glass transition temperature, yield point, and softening point (Ts). The content of $SnO_2$ may be 0.1 to 7% by mole, more preferably 0.2 to 6% by mole, based on the total number of moles of the glass powder.

If the content of $SnO_2$ is less than the above range, the effect of lowering the thermophysical temperatures may be insignificant. If the content of $SnO_2$ exceeds the above range, devitrification substances (especially tetravalent tin substances) caused by Sn are precipitated in the glass when melted, whereby the transmittance tends to deteriorate. As a result, it may be difficult to obtain a wavelength conversion member with high luminescence efficiency, and it may be difficult to vitrify by melt separation.

BaO is a component that lowers melting temperature, thereby improving meltability. It also produces the effect of facilitating glass phase separation and suppressing the reaction with phosphor powder.

The content of BaO may be 1 to 5% by mole, preferably 1 to 4% by mole. If the content of BaO is less than the above range, the effect of improving meltability may be insignificant. If the content of BaO exceeds the above range, the chemical durability decreases, and the tendency of glass phase separation is excessively large, so that even a small change in the thermal treatment temperature may significantly change the state of phase separation. Thus, deviations (imbalances) may occur in light diffusion between lots of wavelength conversion members.

SrO is a component that lowers melting temperature, thereby improving meltability. It also produces the effect of facilitating glass phase separation and suppressing the reaction with phosphor powder.

The content of SrO may be 0.1 to 5% by mole, preferably 0.1 to 4% by mole. If the content of SrO is less than the above range, the effect of improving meltability may be insignificant. If the content of SrO exceeds the above range, the chemical durability deteriorates, and the tendency of glass phase separation is excessively large, so that even a small change in the thermal treatment temperature may significantly change the state of phase separation. Thus, deviations are likely to occur in light diffusion between lots of wavelength conversion members.

CaO is a component that lowers the melting temperature, thereby improving meltability. It also produces the effect of facilitating glass phase separation and suppressing the reaction with phosphor powder.

The content of CaO may be 1 to 5% by mole, preferably 1 to 4% by mole. If the content of CaO is less than the above range, the effect of improving meltability may be insignificant. If the content of CaO exceeds the above range, the chemical durability deteriorates, and the tendency of glass phase separation is excessively large, so that even a small change in the thermal treatment temperature may significantly change the state of phase separation. Thus, deviations are likely to occur in light diffusion between lots of wavelength conversion members.

$Li_2O$ is a component that lowers the softening point. The content of $Li_2O$ may be preferably 1 to 5% by mole, more preferably 2 to 5% by mole, based on the total number of moles of the glass powder.

If the content of $Li_2O$ is less than the above range, the above effect may be insignificant. If the content of $Li_2O$ exceeds the above range, the chemical durability may decrease, and the tendency of glass phase separation is excessively large, resulting in increased light scattering loss. In addition, there may be a problem in that weather resistance deteriorates, and the luminescence intensity deteriorates over time due to light irradiation from a light emitting diode (LED) or laser diode (LD).

$Na_2O$ is a component that lowers the softening point. The content of $Na_2O$ may be preferably 1 to 7% by mole, more preferably 2 to 6% by mole, based on the total number of moles of the glass powder.

If the content of $Na_2O$ is less than the above range, the above effect may be insignificant. If the content of $Na_2O$ exceeds the above range, the chemical durability may decrease, and the tendency of glass phase separation is excessively large, resulting in increased light scattering loss. In addition, there may be a problem in that weather resistance deteriorates, and the luminescence intensity deteriorates over time due to light irradiation from an LED or LD.

$K_2O$ is a component that lowers the softening point. The content of $K_2O$ may be preferably 1 to 5% by mole, more preferably 2 to 5% by mole, based on the total number of moles of the glass powder.

If the content of $K_2O$ is less than the above range, the above effect may be insignificant. If the content of $K_2O$ exceeds the above range, the chemical durability may deteriorate, and the tendency of glass phase separation is excessively large, resulting in increased light scattering loss. In addition, there may be a problem in that weather resistance deteriorates, and the luminescence intensity deteriorates over time due to light irradiation from an LED or LD.

Specifically, the glass powder may further comprise 0.1 to 7% by mole, for example, 0.2 to 6% by mole, of $SnO_2$ and 1 to 10% by mole, for example, 2 to 6% by mole, of $Al_2O_3$ based on the total number of moles of the glass powder.

The glass powder may further comprise 1 to 5% by mole of BaO, 0.1 to 5% by mole of SrO, and 1 to 5% by mole of CaO based on the total number of moles of the glass powder.

The glass powder may further comprise 1 to 5% by mole of $K_2O$, 1 to 5% by mole of $Na_2O$, and 1 to 5% by mole of $Li_2O$ based on the total number of moles of the glass powder.

Alternatively, the glass powder may further comprise $Na_2O$ and $K_2O$, $Na_2O$ and $Li_2O$, or $Li_2O$ and $K_2O$ as alkali metal oxides. When the glass powder comprises the above components in the above combination, it is desirable to appropriately adjust the total content of these components in the range of 2 to 15% by mole, preferably 3 to 10% by mole.

The glass powder may have an average particle diameter (D50) of 2 to 15 μm, preferably 5 to 15 μm.

If the average particle diameter (D50) of the glass powder is less than the above range, the amount of bubbles generated during sintering increases, and bubbles may remain in the wavelength conversion member. The wavelength conversion member may preferably have a porosity of 5% or less, 3% or less, particularly 1% or less. If the porosity exceeds the above range, optical properties may deteriorate. In addition, if a large number of bubbles are contained in the wavelength conversion member, light scattering may be excessive, and fluorescence intensity may be reduced due to scattering loss.

In addition, there is a concern that moisture may easily penetrate the inside of the wavelength conversion member, thereby deteriorating its chemical durability. If the average particle diameter (D50) of the glass powder exceeds the above range, it would be difficult for the phosphor powder to be uniformly dispersed in the wavelength conversion member. As a result, the fluorescence intensity of the wavelength conversion member may deteriorate, or chromaticity deviation may occur.

The glass matrix may have a refractive index of 1.44 to 1.89. Specifically, the refractive index of the glass matrix may preferably be 1.57 to 1.85, more preferably 1.60 to 1.84.

Meanwhile, the glass matrix may have a softening point (Ts) of 550 to 850°C.

Specifically, the softening point (Ts) of the glass matrix may preferably be 550 to 630°C, more preferably 550 to 600°C.

If the softening point (Ts) of the glass matrix is too low, the mechanical strength and chemical durability of the wavelength conversion member may be deteriorated. In addition, since the thermal resistance of the glass matrix itself is low, softening deformation, in which the glass matrix absorbs heat generated from the phosphor and melts to change its shape, may occur. Meanwhile, if the softening point (Ts) of the glass matrix is too high, the phosphor powder may degrade during sintering, thereby decreasing the luminescence intensity of the wavelength conversion member. In addition, the softening point (Ts) of the glass matrix is preferably 550°C or higher from the viewpoint of increasing the chemical stability and mechanical strength of the wavelength conversion member. Examples of such glass include boron silicate-based glass and $P_2O_5$-$ZnO$-$SiO_2$-$B_2O_3$-based glass.

Phosphor powder

According to an embodiment of the present invention, the phosphor powder may be uniformly dispersed in the glass matrix. When the phosphor powder is uniformly dispersed in the glass matrix, a wavelength conversion member with excellent thermal resistance can be provided.

The phosphor powder may comprise a phosphor powder that exhibits fluorescence with a longer wavelength than the wavelength of the excitation light when ultraviolet or visible excitation light is incident. For example, when visible excitation light is incident and a phosphor powder that fluoresces in a color complementary to the color of the excitation light is used, the transmitted excitation light and the fluorescence of the phosphor powder are mixed to produce white light; thus, a white LED can be easily produced. Specifically, when the visible excitation light has a dominant wavelength of 430 to 490 nm and the fluorescence of the phosphor powder has a dominant wavelength of 530 to 590 nm, it may be advantageous for providing white light.

The phosphor powder may have an average particle diameter (D50) of 3 to 30 μm, preferably 3 to 30 μm. If the average particle diameter (D50) of the phosphor powder is less than the above range, the phosphor powder may easily agglomerate with each other to decrease luminescence intensity. If the average particle diameter (D50) of the phosphor powder exceeds the above range, the efficiency of the wavelength conversion member deteriorates, and color deviation increases, which is not desirable.

The type of the phosphor powder is not particularly limited. Example thereof include nitride phosphor powder, oxynitride phosphor powder, oxide phosphor powder (including garnet-based phosphor powder such as YAG phosphor powder), sulfide phosphor powder, oxysulfide phosphor powder, halide phosphor powder (such as fluoride and chloride), and aluminic acid chloride phosphor. Nitride phosphor powder, oxynitride phosphor powder, and oxide phosphor powder among the above phosphor powders have high thermal resistance and are not easily degraded during sintering, and are particularly suitable as phosphor powder used in a wavelength conversion member for white LED devices.

In addition, the phosphor powder is preferably an oxide phosphor powder or an aluminic acid chloride phosphor powder from the viewpoint of increasing quantum conversion efficiency.

The oxide phosphor or aluminic acid chloride phosphor may comprise at least one phosphor powder selected from the group consisting of yttrium-aluminum-garnet (YAG)-based, lutetium-aluminum-garnet (LuAG)-based, nitride-based, sulfide-based, and silicate-based materials.

The phosphor powder may be a phosphor powder having an emission wavelength range of a visible wavelength range, for example, 380 nm to 780 nm.

Specifically, the phosphor powder may comprise at least one selected from blue, green, red, and yellow light-emitting particles. Here, the blue, green, red, and yellow light-emitting particles refer to particles that exhibit blue, green, red, and yellow fluorescence, respectively.

The blue light-emitting particles may comprise a phosphor powder having an emission wavelength range of 440 nm to 480 nm. The green light-emitting particles may comprise a phosphor powder having an emission wavelength range of 500 nm to 540 nm. The yellow light-emitting particles may comprise a phosphor powder having an emission wavelength range of greater than 540 nm to 595 nm. The red light-emitting particles may comprise a phosphor powder having an emission wavelength range of 660 nm to 700 nm.

Specifically, when irradiated with excitation light of ultraviolet to near-ultraviolet rays having a wavelength of 300 nm to 440 nm, the blue light-emitting particles may be $(Sr,Ba)MgAl_{10}O_{17}:Eu^{2+}$; $(Sr,Ba)_3MgSi_2O_8:Eu^{2+}$.

When irradiated with excitation light of ultraviolet to near-ultraviolet rays having a wavelength of 300 nm to 440 nm, the green light-emitting particles may be $SrAl_2O_4:Eu^{2+}$; $SrBaSiO_4:Eu^{2+}$; $(Y,Lu)_3(Al,Gd)_5O_{12}:Ce^{3+}$; $SrSiON:Eu^{2+}$; $BaMgAl_{10}O_{17}:Eu^{2+}, Mn^{2+}$; $Ba_2MgSi_2O_7Eu^{2+}$; $Ba_2SiO_4:Eu^{2+}$; $Ba_2Li_2Si_2O_7:Eu^{2+}$; $BaAl_2O_4:Eu^{2+}$. When irradiated with blue excitation light having a wavelength of 440 nm to 480 nm, the green light-emitting particles may be $SrAl_2O_4:Eu^{2+}$; $SrBaSiO_4:Eu^{2+}$; $(Y,Lu)_3(Al,Gd)_5O_{12}:Ce^{3+}$; $SrSiON:Eu^{2+}$; $\beta$-SiAlON: $Eu^{2+}$.

When irradiated with excitation light of ultraviolet to near-ultraviolet rays having a wavelength of 300 nm to 440 nm, the yellow light-emitting particles may be $La_3Si_6N_{11}:Ce^{3+}$. When irradiated with blue excitation light having a wavelength of 440 nm to 480 nm, the yellow light-emitting particles may be $(Y,Lu)_3(Al,Gd)_5O_{12}:Ce^{3+}$; $Sr_2SiO_4:Eu^{2+}$.

When irradiated with excitation light of ultraviolet to near-ultraviolet rays having a wavelength of 300 nm to 440 nm, the red light-emitting particles may be $CaGa_2S_4:Mn^{2+}$; $MgSr_3Si_2O_8:Eu^{2+}, Mn^{2+}$; $Ca_2MgSi_2O_7:Eu^{2+}, Mn^{2+}$. When irradiated with blue excitation light having a wavelength of 440 nm to 480 nm, the red light-emitting particles may be $CaAlSiN_3:Eu^{2+}$; $CaSiN_3:Eu^{2+}$; $(Ca,Sr)_2Si_5N_8: Eu^{2+}$; $\alpha$-SiAlON: $Eu^{2+}$.

According to an embodiment of the present invention, various phosphor powders may be mixed and used depending on the excitation light and emission wavelength. For example, when excitation light in the ultraviolet region is irradiated to produce white light, a phosphor powder containing blue, green, yellow, or red light-emitting particles may be used.

The phosphor powder may have a refractive index of 1.5 to 2.4.

In addition, in the wavelength conversion member of the present invention, the difference in refractive index between the glass matrix and the phosphor powder may be, for example, less than 0.05, preferably less than 0.03. When the difference in refractive index between the glass matrix and the phosphor powder is small, appropriate scattering and light diffusion can be achieved, which may be more advantageous for producing the desired effect in the present invention.

According to an embodiment of the present invention, the content of the phosphor powder in the wavelength conversion member may be 5 to 50% by weight, preferably 10 to 40% by weight, more preferably 10 to 30% by weight, based on the total weight of the glass matrix, spherical silica filler powder, and phosphor powder.

If the content of the phosphor powder is too small, the amount of light emitted is insufficient, making it difficult to obtain the desired white light. If the content of the phosphor powder is too large, sintering would be difficult, and there is a concern that the fluorescence intensity may deteriorate because excitation light is not sufficiently irradiated to the entire phosphor powder. In addition, pores are likely to be formed within the wavelength conversion member, making it difficult to obtain a dense structure.

Spherical silica filler powder

According to an embodiment of the present invention, the wavelength conversion member comprises spherical silica filler powder.

In the wavelength conversion member comprising the spherical silica filler powder, both the glass matrix and the spherical silica filler powder are made of glass; thus, it is possible to minimize the occurrence of heterogeneous layers or voids at the interface between them.

The spherical silica filler powder may be uniformly dispersed in the glass matrix. If the spherical silica filler powder is uniformly dispersed in the glass matrix, thermal resistance can be enhanced, and the decrease in fluorescence intensity and the occurrence of chromaticity deviation can be minimized.

The wavelength conversion member of the present invention comprises spherical silica filler powder and is characterized by having a particle size distribution in a specific range, that is, a D50 of 1.0 to 15.0 $\mu$m and a SPAN value of 1.0 to 5.0.

Specifically, the spherical silica filler powder may have a D50 1.0 to 15.0 $\mu$m, preferably 1.2 to 13.2 $\mu$m, more preferably 2.0 to 6.0 $\mu$m. If the D50 of the spherical silica filler powder is less than the above range, there is a concern that the spherical silica filler powder may aggregate to decrease the light transmittance of the wavelength conversion member. Meanwhile, if the D50 of the spherical silica filler powder exceeds the above range, the distribution of the spherical silica filler powder in the wavelength conversion member may not be uniform, which decreases the fluorescence intensity of the wavelength conversion member or increases chromaticity deviation. In addition, there is a concern that the wavelength conversion member may be shrunk during sintering. Meanwhile, if the spherical silica filler powder has a D50 satisfying the above range, the distance between the spherical silica filler particles or between the spherical silica filler powder and the phosphor powder is shortened, allowing heat to be effectively dissipated to the outside.

The spherical silica filler powder may have a SPAN value of 1.0 to 5.0, preferably 1.0 to 4.5, more preferably 1.0 to 3.0.

The SPAN value is an indicator standing for the particle size distribution of the spherical silica filler powder. Specifically, the SPAN value is an indicator of the ratio of silica powder present mainly as fine particles and silica powder present as slightly larger particles in the spherical silica powder in terms of particle size and amount.

As the SPAN value satisfies the above range, a decrease in the fluorescence intensity of the wavelength conversion member or chromaticity imbalance can be preferably suppressed.

If the SPAN value is less than the above range, the spherical silica filler powder is likely to re-agglomerate to form large-sized aggregates in the preparation of a wavelength conversion member. In such a case, it is undesirable because too much scattering may occur at a level that prevents light transmission beyond the effective range. Meanwhile, if the SPAN value of the spherical silica filler powder exceeds the above range, the ratio of fine silica filler powder to coarse silica filler powder becomes relatively large, making it difficult to form a paste.

If the SPAN value satisfies the above range, a particle size distribution that is bilaterally symmetrical can be obtained, or a particle size distribution that is not bilaterally symmetrical, in which the base on the coarse side is short and the base on the fine side is long, can be obtained.

In the present invention, the particle size of the spherical silica filler powder was measured using S3500 equipment of Microtreac. D10, D50, and D90 of the analyzed values were measured as the particle diameter (D10) when the cumulative volume concentration (%) was 10%, the particle diameter (D50) when the cumulative volume concentration (%) was 50%, and the particle diameter (D90) when the cumulative volume concentration (%) was 90%, respectively, in the particle size distribution measurement by a laser light diffraction method. The SPAN value may be calculated using the above Equation 1.

In addition, the spherical silica filler powder may have a D90/D10 (DSPAN) of 1.5 to 15, preferably 1.5 to 13, more preferably 1.5 to 10.

The D90/D10 (DSPAN) value is an indicator standing for the ratio of particle size distribution to particle size of the spherical silica filler powder. Specifically, the D90/D 10 (DSPAN) value is an indicator of the ratio of silica powder present mainly as fine particles and silica powder present as slightly larger particles in the spherical silica filler powder in terms of particle size and amount.

If the D90/D10 (DSPAN) value satisfies the upper limit of the range, the particle size distribution curve of the spherical silica filler powder shows a sharp shape. If the D90/D10 (DSPAN) value of the spherical silica filler powder satisfies the above range, the shrinkage of the wavelength conversion member during sintering can be suppressed, whereby uniform dispersion of the phosphor particles in the wavelength conversion member can be preferably maintained.

The spherical silica filler powder may have a specific surface area (Brunauer-Emmett-Teller; BET) of 1.0 to 6.5 m$^2$/g, preferably 2.0 to 5.0 m$^2$/g, more preferably 2.0 to 4.0 m$^2$/g.

If the specific surface area of the spherical silica filler powder is less than the above range, there is a concern that agglomerates of the silica filler powder may increase to decrease the light transmittance of the wavelength conversion member. Meanwhile, if the specific surface area of the spherical silica filler powder exceeds the above range, the dispersibility of the spherical silica filler powder in the wavelength conversion member may deteriorate, which decreases the fluorescence intensity of the wavelength conversion member or increases chromaticity deviation.

The specific surface area can be measured by the BET method by nitrogen adsorption. For example, a specific surface area measuring device (Macsorb HM (model 1210) of MOUNTECH, Belsorp-mini II of Microtrac BEL, or the like) generally used in the art may be used.

Since the spherical silica filler powder has a spherical shape, it can increase light scattering (scattering of excitation light), which is consequently advantageous for obtaining a wavelength conversion member capable of irradiating light with uniform and high fluorescence intensity.

Meanwhile, the spherical silica filler powder may have an average sphericity of 2.0 or less, preferably 1.5 or less.

In the present invention, "sphericity" refers to "diameter of the major axis ($L_{max}$)/diameter of the minor axis ($L_{min}$)" for particles observed with a scanning electron microscope (SEM).

Referring to Fig. 2, the diameter of the major axis ($L_{max}$) may refer to the length ($L_{max}$) of the longest straight line when two arbitrary points on the outline of the spherical silica filler powder (130) are connected with a straight line. The diameter of the minor axis ($L_{min}$) may refer to the length ($L_{min}$) of the shortest straight line when two arbitrary points on the outline of the spherical silica filler powder are connected with a straight line.

According to an embodiment of the present invention, the spherical silica filler powder may contain a certain number of particles having a relatively small particle size. In such a case, if the spherical silica filler powder is not perfectly spherical, silica filler powder with a relatively small particle size may enter the gaps between the particles to fill the gaps. In light of the above, the average sphericity of the spherical silica filler powder may be 1.1 to 1.5.

Meanwhile, the spherical silica filler powder may have a refractive index of 1.44 to 1.47.

In addition, the difference in refractive index between the glass matrix and the spherical silica filler powder may be 0.01 to 0.52, preferably 0.12 to 0.50, more preferably 0.33 to 0.40.

If the difference in refractive index between the glass matrix and the spherical silica filler powder is too large, the light reflectance at the interface between the glass matrix and the spherical silica filler powder increases, causing excessive light scattering, which may decrease light efficiency. It may be difficult for the excitation light to irradiate the phosphor powder inside the wavelength conversion member, resulting in a decrease in fluorescence intensity. If the difference in refractive index between the glass matrix and the spherical silica filler powder is too small, it may be difficult to obtain sufficient light scattering, thereby decreasing luminous intensity, and there may be difficulty in obtaining the desired effect in the present invention.

Meanwhile, the softening point (Ts) of the spherical silica filler powder is higher than the softening point (Ts) of the glass matrix preferably by 500°C or more. In such a case, it is possible to prevent the silica powder from softening and flowing and the light diffusivity from deteriorating in the preparation of the wavelength conversion member. Specifically, the softening point (Ts) of the spherical silica filler powder may be 1,400 to 1,700°C, preferably 1,400 to 1,600°C.

The content of the spherical silica filler powder may be 0.5 to 50% by weight based on the total weight of the glass matrix, spherical silica filler powder, and phosphor powder. Specifically, the content of the spherical silica filler powder may be preferably 0.5 to 30% by weight, more preferably 1 to 20% by weight, based on the total weight of the glass matrix, spherical silica filler powder, and phosphor powder. If the content of the spherical silica filler powder is less than the above range, the effect of the filler cannot be sufficiently produced. If the content of the spherical silica filler powder exceeds the above range, light scattering may be excessive, resulting in an increased loss and a reduced light efficiency.

In addition, if the difference in refractive index between the phosphor powder and the glass matrix is relatively large, light scattering is likely to occur; thus, it may be difficult to obtain the effect of the filler even if the spherical silica filler powder is added.

Thus, it is desirable to appropriately determine the content of silica powder in light of the difference in refractive index between the phosphor powder and the glass matrix.

According to an embodiment of the present invention, the content of the glass powder and spherical silica filler powder forming the glass matrix may vary depending on the content of the phosphor powder.

Specifically, the weight ratio (X:Y) of the content of a mixture (X) of the glass powder and the spherical silica filler powder to the phosphor powder (Y) may be 60 to 95:5 to 40, preferably 70 to 95:5 to 30. If the mixture (X) of the glass powder and the spherical silica filler powder is less than the above range, the sinterability deteriorates, which decreases the transmittance of the wavelength conversion member, and the desired white light cannot be obtained.

If the weight ratio (X:Y) of the content of a mixture (X) of the glass powder and the spherical silica filler powder to the phosphor powder (Y) satisfies the above range, the light transmittance from the light source and the light conversion amount of the phosphor powder can be controlled in a balanced manner, and the shrinkage in the size of the wavelength conversion member can be suppressed in the preparation of the wavelength conversion member, whereby the occurrence of spotting in the light conversion chromaticity can be minimized.

According to an embodiment of the present invention, the weight ratio of the phosphor powder and the spherical silica filler powder may be 1:0.1 to 5.

Characteristics of the wavelength conversion member

The wavelength conversion member according to an embodiment of the present invention may have a thickness of 100 to 800 μm, preferably 150 to 500 μm. If the thickness of the wavelength conversion member is equal to, or greater than, the lower limit of the above range, it is convenient to handle, and cracking can be prevented when the wavelength conversion member is cut to a desired size. In addition, if the thickness of the wavelength conversion member is equal to, or less than, the upper limit of the above range, the amount of luminous flux passing through the wavelength conversion member can be kept high. If the thickness of the wavelength conversion member is too thick beyond the above range, the luminescence efficiency of the phosphor may be lowered.

The wavelength conversion member may have a light transmittance of 70 to 95%. Specifically, the wavelength conversion member may have a light transmittance of 72 to 92% or 72.2 to 85%.

The wavelength conversion member may have a luminous flux (Φv) of 66 to 80 lm. Specifically, the wavelength conversion member may have a luminous flux (Φv) of 73 to 80 lm or 74 to 80 lm.

The wavelength conversion member may have a converted luminous flux of 98% to 105%. Specifically, the wavelength conversion member may have a converted luminous flux of 98% to 103% or 100% to 103%.

The luminous flux and converted luminous flux may be measured by the chromaticity distribution using an excitation light source of 445 nm using an integrating sphere measurement equipment (LMS-200, J&C Tech.).

Meanwhile, the wavelength conversion member may have a parallel light (straight line) transmittance of 20% or less, preferably 10% or less, as measured according to JIS K7105. If the parallel light transmittance is too large, the light propagation is too large, which may cause a decrease in fluorescence intensity and a deviation in color.

In addition, the wavelength conversion member may have a haze of 70% or more, preferably 75% or more, as measured according to JIS K7105.

**[Process for preparing a wavelength conversion member]**

The present invention provides a process for preparing a wavelength conversion member.

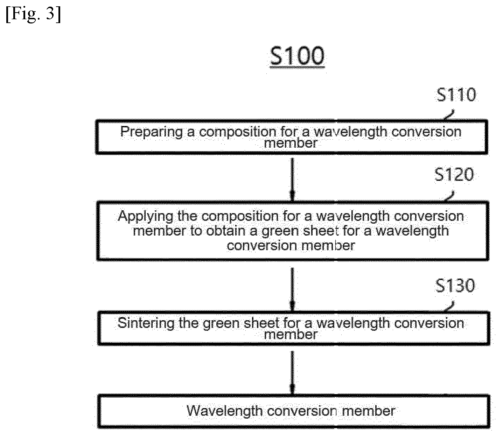

Referring to Fig. 3, the process for preparing a wavelength conversion member according to an embodiment of the present invention may comprise a first step of obtaining a composition for a wavelength conversion member comprising glass powder, phosphor powder, and spherical silica filler powder (S110); a second step of applying the composition for a wavelength conversion member onto a substrate to obtain a green sheet for a wavelength conversion member (S120); and a third step of sintering the green sheet for a wavelength conversion member (S130).

Specifically, the first step (S110) comprises obtaining a composition for a wavelength conversion member comprising glass powder, phosphor powder, and spherical silica filler powder.

Specifically, a composition comprising glass powder capable of forming a glass matrix, phosphor powder, and spherical silica filler powder may be prepared. The types and contents of the glass powder, phosphor powder, and spherical silica filler powder are as described above.

According to an embodiment of the present invention, the content of each component in the composition for a wavelength conversion member can be considered to be the same as the content of each component contained in the wavelength conversion member after sintering.

In addition, the composition for a wavelength conversion member may further comprise a binder resin and a solvent.

The binder resin may comprise at least one selected from the group consisting of polyvinyl butyral (PVB), polyvinyl alcohol (PVA), and poly(vinyl acetate) (PVAc). Specifically, the binder resin may comprise polyvinyl butyral (PVB) or polyvinyl alcohol (PVA).

The binder resin may have a weight average molecular weight of 1,000 to 70,000 g/mole. Specifically, the binder resin may have a weight average molecular weight of 20,000 to 60,000 g/mole.

The solvent may have a low boiling point for the rapid preparation of a green sheet. Specifically, the solvent may have a boiling point of 30 to 150°C. More specifically, the solvent may have a boiling point of 60 to 130°C.

In addition, the solvent may comprise at least one selected from the group consisting of toluene, ethanol, butanol, acetone, and methanol. Specifically, the solvent may comprise at least one selected from the group consisting of toluene, ethanol, and butanol. For example, the solvent may comprise toluene, ethanol, and butanol.

The solvent may be contained in an amount suitable for the characteristics and drying conditions of the composition. Specifically, the solvent may be contained in an amount of 30 to 50% by weight based on the total weight of the composition for a wavelength conversion member.

In addition, the composition for a wavelength conversion member may further comprise a plasticizer. The plasticizer may comprise at least one selected from the group consisting of DOP (dioctyl phthalate), DOA (dioctyl adipate), and TCP (tricresyl phosphorate). Specifically, the plasticizer may comprise DOP (dioctyl phthalate) or DOA (dioctyl adipate).

In addition, the plasticizer may be contained in an amount of 10 to 200 parts by weight based on 100 parts by weight of the binder resin. Specifically, the plasticizer may be contained in an amount of 30 to 90 parts by weight based on 100 parts by weight of the binder resin.

The composition for a wavelength conversion member may be prepared by mixing a solvent and a binder resin, removing air bubbles to obtain a binder solution, and then mixing the binder solution, glass powder, phosphor powder, spherical silica filler powder, and a plasticizer. In the present invention, a solvent having a low boiling point is used, whereby the binder resin and the solvent can be mixed at room temperature in the preparation of the composition for a wavelength conversion member.

The second step (S120) comprises applying the composition for a wavelength conversion member onto a substrate to obtain a green sheet for a wavelength conversion member.

Specifically, the composition for a wavelength conversion member obtained in the first step is applied onto a substrate. Here, the application may be carried out using a tape casting method or a doctor blade.

The substrate may be a polyester-based substrate, for example, a resin film such as polyethylene terephthalate (PET).

According to an embodiment of the present invention, the green sheet for a wavelength conversion member may be one sheet or may be one obtained by laminating a plurality of green sheets for a wavelength conversion member, each of which is prepared by casting, followed by compressing them. In such an event, the number of laminations of the green sheet for a wavelength conversion member is not particularly limited. For example, it may be laminated such that the thickness of the green sheet for a wavelength conversion member upon compression is 50 to 1,500 $\mu$m.

The compression may be carried out at a pressure of 1 to 100 MPa. Specifically, the compression may be carried out at a pressure of 2 to 50 MPa.

The third step (S130) comprises sintering the green sheet for a wavelength conversion member.

The sintering temperature is preferably within the range of $\pm$ 100°C of the softening point of the glass matrix, specifically within the range of $\pm$50°C of the softening point of the glass matrix. If the sintering temperature is too low, fusion of each layer may be difficult, sintering of the glass powder may be insufficient, or the mechanical strength of the wavelength conversion member may deteriorate. Meanwhile, if the sintering temperature is too high, the luminescence intensity of the wavelength conversion member may decrease.

The sintering may be carried out at 450 to 950°C for 10 minutes to 72 hours. Specifically, the sintering may be carried out at 600 to 800°C for 10 minutes to 52 hours.

Meanwhile, in each of the above preparation processes, a degreasing step may be carried out to remove organic substances before sintering, that is, after the green sheet for a wavelength conversion member is compressed and before sintered. In addition, when a plurality of green sheets for a wavelength conversion member are contained, each layer may be appropriately heated and pressed to increase adhesion to each other when it is laminated.

In addition, the preparation process may further comprise processing steps such as grinding, polishing, and re-pressing, if necessary, after sintering.

**[Light emitting device]**

An embodiment of the present invention provides a light emitting device, which comprises the wavelength conversion member; and a light source that irradiates excitation light to the wavelength conversion member.

Specifically, the wavelength conversion member, along with a light source that irradiates excitation light to the phosphor powder, may be used as a light emitting device. The light source may be a semiconductor light emitting device such as a light emitting diode (LED) and a laser diode (LD). A plurality of the semiconductor light emitting devices may be used.

The light emitting device may be arranged such that the wavelength conversion member is in direct contact with the semiconductor light emitting device. For example, the semiconductor light emitting device and the wavelength conversion member may have a sequentially stacked structure. Alternatively, the semiconductor light emitting device may be arranged to be surrounded by the wavelength conversion member, or the wavelength conversion member may be arranged to be surrounded by the semiconductor light emitting device.

In addition, the semiconductor light emitting device and the wavelength conversion member may be spaced apart from each other.

**Mode for the Invention**

Hereinafter, the present invention will be described in more detail with reference to the following examples. However, these examples are provided to illustrate the present invention, and the scope of the present invention is not limited thereto only.

**Preparation Example 1: Preparation of glass powder**

The respective components were mixed to have a composition shown in Table 1 below and melted at 1,200°C to prepare glass. The glass thus prepared was pulverized to prepare a glass powder having an average particle diameter of 5.9 $\mu$m.

[Table 1]

| | Preparation Example 1 | % by mole |
|---|---|---|
| Composition of glass powder | $P_2O_5$ | 5.2 |
| | ZnO | 33.5 |
| | $SiO_2$ | 17.8 |
| | $B_2O_3$ | 18.6 |
| | $Al_2O_3$ | 3.7 |
| | $SnO_2$ | 5.2 |
| | CaO | 3.7 |
| | $Li_2O$ | 2.6 |
| | $Na_2O$ | 5.7 |
| | $K_2O$ | 4 |
| D50 | 5.9 $\mu$m | |

**Example 1: Preparation of a wavelength conversion member**

1-1: Preparation of a composition for a wavelength conversion member

As shown in Table 2 below, 80% by weight of the glass powder of Preparation Example 1, 10% by weight of YAG-based phosphor powder (average particle diameter (D50): 25 $\mu$m, manufacturer: Daejoo Electronic Materials, product name: DLP-Y62-25), 10% by weight of spherical silica filler powder (DENKA/FB-7SDX) were mixed with a binder solution and a plasticizer at a ratio of 85:15 to prepare a composition for a wavelength conversion member.

Here, the binder solution was prepared by adding 27 g of polyvinyl butyral (PVB, weight average molecular weight: 50,000 g/mole) to 81 g of a solvent (a mixture of toluene and butanol at a volume ratio of 3:2) and dissolved at room temperature for 1 hour, and the plasticizer was a phthalate-based plasticizer.

1-2: Preparation of a green sheet for forming a wavelength conversion member

The composition for a wavelength conversion member prepared in step 1-1 above was applied onto a PET film by a tape casting method and molded into a sheet to obtain a green sheet for a wavelength conversion member having a thickness of 50 $\mu$m. 21 sheets of the above green sheet were laminated and pressed at a pressure of 14 MPa to obtain a green sheet for a wavelength conversion member.

1-3: Sintering of the green sheet for a wavelength conversion member

The green sheet for a wavelength conversion member prepared in step 1-2 above was sintered at 600°C for 12 hours to obtain a wavelength conversion member.

**Examples 2 to 7**

Wavelength conversion members were each prepared in the same manner as in Example 1, except that spherical silica filler powder with a different particle size distribution was used in step 1-1 of Example 1, and the contents of the glass powder, spherical silica filler powder, and phosphor powder were adjusted, as shown in Table 2 below.

**Comparative Example 1**

A wavelength conversion member was prepared in the same manner as in Example 1, except that no spherical silica filler powder was used in step 1-1 of Example 1, and the content of the glass powder was changed to 90% by weight, as shown in Table 2 below.

**Comparative Example 2**

A wavelength conversion member was prepared in the same manner as in Example 1, except that prismatic silica filler powder (Amotech, abp-05) was used instead of the spherical silica filler powder in step 1-1 of Example 1 as shown in Table 2 below.

**Comparative Example 3**

A wavelength conversion member was prepared in the same manner as in Example 1, except that spherical fumed silica filler powder (Evonik, Aerosil R-202) with a different particle size distribution was used instead of the spherical silica filler powder in step 1-1 of Example 1 as shown in Table 2 below.

**Comparative Examples 4 and 5**

Wavelength conversion members were each prepared in the same manner as in Example 1, except that spherical silica filler powder with a SPAN value of 1.4 and 5.4, respectively, and a different particle size distribution was used in step 1-1 of Example 1 as shown in Table 2 below.

**Test Example**

Each component used in the Examples and Comparative Examples or each wavelength conversion member prepared in the Examples and Comparative Examples were evaluated for the physical properties in the following manner. The results are shown in Tables 2 and 3.

(1) Softening point (Ts)

The softening point (softening temperature) was measured using a thermal analyzer (SDT: Q600, TA Instruments, USA) at a temperature elevation rate of 10°C/minute from room temperature to 1,000°C.

(2) Refractive index

The refractive index was measured using Professional Gemstone Refractometers (Kruess model ER601 LED, Germany). For the measurement, a specimen was processed to a thickness of 1 mm (1T), and then a certain amount of a refractive solution was applied to the specimen measurement position so as to be in close contact with the measurement portion.

(3) Particle diameter

The particle diameter was measured using S3500 equipment of Microtreac. D10, D50, and D90 of the analyzed values were measured as the particle diameter (D10) when the cumulative volume concentration (%) was 10%, the particle diameter (D50) when the cumulative volume concentration (%) was 50%, and the particle diameter (D90) when the cumulative volume concentration (%) was 90%, respectively, in the particle size distribution measurement by a laser light diffraction method.

(4) BET

The silica filler powders used in the Examples and Comparative Examples were measured for specific surface area with Macsorb HM (model 1210) of MOUNTECH by the BET one-point method with a flow of a mixed gas of nitrogen and helium ($N_2$: 30% by volume and He: 70% by volume).

(5) Light transmittance (%)

The transmittance of light having a reference wavelength of 550 nm was measured using a UV/Vis spectrometer (Lambda35, USA) of PerkinElmer. The light transmittance was 100% when a sample was not present.

(6) Chromaticity distribution (Cx, Cy, luminous flux ($\Phi v$, lumen (lm)), and converted luminous flux (%))

The chromaticity distribution was measured by placing a wavelength conversion member on an excitation light source of 445 nm in an integrating sphere measuring device (LMS-200, J & C Tech.).

[Table 2]

| | | Ex. | | | | | | | C. Ex. | | | | |
| | | 1 | 2 | 3 | 4 | 5 | 6 | 7 | 1 | 2 | 3 | 4 | 5 |
|---|---|---|---|---|---|---|---|---|---|---|---|---|---|
| Silica filler powder | Type | Sp. | Sp. | Sp. | Sp. | Sp. | Sp. | Sp. | × | Pr. | Sp. | Sp. | Sp. |
| | D90 ($\mu$m) | 8.91 | 6.16 | 11.4 | 2.3 | 26.8 | 5.71 | 8.91 | × | 15.5 | 0.38 | 30.8 | 43.8 |
| | D50 ($\mu$m) | 4.62 | 1.62 | 5.36 | 1.23 | 13.2 | 3.82 | 4.62 | × | 6.59 | 0.33 | 18.6 | 7.89 |
| | D10 ($\mu$m) | 1.63 | 0.63 | 1.51 | 0.26 | 2.13 | 1.45 | 1.63 | × | 2.6 | 0.18 | 5.1 | 1.23 |
| | (D90-D10)/D50 | 1.6 | 4.5 | 1.8 | 1.7 | 1.9 | 1.1 | 1.6 | × | 2.0 | 0.6 | 1.4 | 5.4 |
| | D90/D10 | 5.5 | 12.6 | 7.5 | 14.4 | 12.8 | 3.9 | 5.5 | × | 6.0 | 2.1 | 6.0 | 35.4 |
| | BET (m$^2$/g) | 3.5 | 3.5 | 2.1 | 6.2 | 1.3 | 4 | 3.5 | × | 2.2 | 80 | 0.5 | 1.6 |
| Comp. (wt%) | Silica filler P. | 10 | 20 | 20 | 5 | 10 | 20 | 20 | 0 | 10 | 10 | 10 | 10 |
| | Phosphor P. | 10 | 10 | 15 | 15 | 5 | 10 | 15 | 10 | 10 | 10 | 10 | 10 |
| | Glass P. | 80 | 70 | 65 | 80 | 85 | 70 | 65 | 90 | 80 | 80 | 80 | 80 |

[Table 3]

| | | Ex. | | | | | | | C. Ex. | | | | |
| | | 1 | 2 | 3 | 4 | 5 | 6 | 7 | 1 | 2 | 3 | 4 | 5 |
|---|---|---|---|---|---|---|---|---|---|---|---|---|---|
| Light pr. | Light trans. (%) | 72.6 | 72.6 | 72.7 | 72.3 | 72.5 | 72.7 | 72.7 | 72.1 | 64.4 | 68.5 | 71.5 | 70.6 |
| | Cx | 0.329 | 0.339 | 0.345 | 0.347 | 0.313 | 0.344 | 0.344 | 0.324 | 0.341 | 0.34 | 0.303 | 0.346 |
| | Cy | 0.351 | 0.368 | 0.37 | 0.371 | 0.336 | 0.371 | 0.371 | 0.373 | 0.373 | 0.374 | 0.311 | 0.371 |
| | Luminous flux (lm) | 76.3 | 77.8 | 78.6 | 77.9 | 73.6 | 78.5 | 78.5 | 73.4 | 69.5 | 72.3 | 68.8 | 76.5 |
| | Conv. Luminous flux (%) | 100.8 | 101.7 | 100.9 | 100.3 | 100.3 | 102.1 | 102.1 | 100 | 87.3 | 95.9 | 96.5 | 96.7 |

As can be seen from Table 3 above, the wavelength conversion members of Examples 1 to 7, in which the wavelength conversion member comprised phosphor powder and spherical silica filler powder dispersed in a glass matrix, and the spherical silica filler powder had a D50 of 1.23 to 13.2 $\mu$m and a SPAN value of 1.1 to 4.5, were overall excellent in optical properties such as light transmittance, luminous flux, and converted luminous flux.

Specifically, the wavelength conversion members of Examples 1 to 7 had a light transmittance of 72.3 to 72.7%, a luminous flux of 73.6 to 78.6 lm, and a converted luminous flux of 100.3 to 102.2%, which were all excellent.

In contrast, the wavelength conversion member of Comparative Example 1, which contained no silica filler powder, that of Comparative Example 2 containing prismatic silica filler powder, and those of Comparative Examples 3 to 5, in which any of the D50 and SPAN values of the spherical silica filler powder were outside the scope of the present invention, were deteriorated in all optical properties such as light transmittance, luminous flux, and converted luminous flux as compared with the wavelength conversion members of Examples 1 to 7.

[Reference Numerals of the Drawings]

100: wavelength conversion member
110: glass matrix
120: phosphor powder
130: spherical silica filler powder

Lmax: diameter of major axis
Lmin: diameter of minor axis

**Claims**

1. A wavelength conversion member, which comprises a glass matrix; and phosphor powder and spherical silica filler powder dispersed in the glass matrix, wherein, when the particle sizes representing 10%, 50%, and 90% of the cumulative volume (%) in a particle size distribution measured by laser diffraction are D10, D50, and D90, respectively, D50 of the spherical silica filler powder is 1.0 to 15.0 $\mu$m, and the SPAN value of the following Equation 1 is 1.0 to 5.0:

$$[\text{Equation 1}]$$

$$\text{Span} = (\text{D90} - \text{D10})/\text{D50}.$$

2. The wavelength conversion member of claim 1, wherein the spherical silica filler powder has a D90/D10 of 1.5 to 15.

3. The wavelength conversion member of claim 1, wherein the spherical silica filler powder has a specific surface area (Brunauer-Emmett-Teller; BET) of 1.0 to 6.5 $m^2$/g.

4. The wavelength conversion member of claim 1, wherein the difference in refractive index between the glass matrix and the spherical silica filler powder is 0.01 to 0.52.

5. The wavelength conversion member of claim 4, wherein the glass matrix has a refractive index of 1.44 to 1.89 and a softening point (Ts) of 550 to 850°C.

6. The wavelength conversion member of claim 1, wherein the phosphor powder has an average particle diameter (D50) of 3 to 30 $\mu$m.

7. The wavelength conversion member of claim 1, wherein the content of the spherical silica filler powder is 0.5 to 50% by weight based on the total weight of the glass matrix, the spherical silica filler powder, and the phosphor powder.

8. The wavelength conversion member of claim 1, wherein the weight ratio of the phosphor powder and the spherical silica filler powder is 1:0.1 to 5.

9. The wavelength conversion member of claim 1, wherein the glass matrix is derived from glass powder having an average particle diameter (D50) of 2 to 15 $\mu$m, and
   the glass powder has the following composition based on the total number of moles of the glass powder:

   2 to 10% by mole of $P_2O_5$,
   30 to 50% by mole of ZnO,
   10 to 25% by mole of $SiO_2$, and
   15 to 25% by mole of $B_2O_3$.

10. The wavelength conversion member of claim 9, wherein the glass powder further comprises at least one selected from the following components:

    1 to 10% by mole of $Al_2O_3$,
    0.1 to 7% by mole of $SnO_2$,
    1 to 5% by mole of BaO,
    0.1 to 5% by mole of SrO,
    1 to 5% by mole of CaO,
    1 to 5% by mole of $Li_2O$,
    1 to 7% by mole of $Na_2O$, and
    1 to 5% by mole of $K_2O$.

11. A process for preparing the wavelength conversion member of claim 1, which comprises:

a first step of obtaining a composition for a wavelength conversion member comprising glass powder, phosphor powder, and spherical silica filler powder;

a second step of applying the composition for a wavelength conversion member onto a substrate to obtain a green sheet for a wavelength conversion member; and

a third step of sintering the green sheet for a wavelength conversion member.

12. A light emitting device, which comprises the wavelength conversion member of any one of claims 1 to 10; and a light source that irradiates excitation light to the wavelength conversion member.

**Patentansprüche**

1. Wellenlängenumwandlungselement, das eine Glasmatrix; und Phosphorpulver und kugelförmiges Siliciumdioxidfüllstoffpulver, die in der Glasmatrix dispergiert sind, umfasst,

   wobei, wenn die Partikelgrößen, die 10 %, 50 % und 90 % des kumulativen Volumens (%) in einer Partikelgrößenverteilung gemessen durch Laserbeugung darstellen, jeweils D10, D50 und D90 sind, D50 des kugelförmigen Siliciumdioxidfüllstoffpulvers 1,0 bis 15,0 $\mu$m ist und der SPAN-Wert der folgenden Gleichung 1 1,0 bis 5,0 ist:

$$[\text{Gleichung 1}]$$

$$\text{Span} = (D90 - D10)/D50.$$

2. Wellenlängenumwandlungselement nach Anspruch 1, wobei das kugelförmige Siliciumdioxidfüllstoffpulver eine D90/D10 von 1,5 bis 15 aufweist.

3. Wellenlängenumwandlungselement nach Anspruch 1, wobei das kugelförmige Siliciumdioxidfüllstoffpulver eine spezifische Oberfläche (Brunauer-Emmett-Teller; BET) von 1,0 bis 6,5 $m^2$/g aufweist.

4. Wellenlängenumwandlungselement nach Anspruch 1, wobei die Differenz im Brechungsindex zwischen der Glasmatrix und dem kugelförmigen Siliciumdioxidfüllstoffpulver 0,01 bis 0,52 ist.

5. Wellenlängenumwandlungselement nach Anspruch 4, wobei die Glasmatrix einen Brechungsindex von 1,44 bis 1,89 und einen Erweichungspunkt (Ts) von 550 bis 850 °C aufweist.

6. Wellenlängenumwandlungselement nach Anspruch 1, wobei das Phosphorpulver einen durchschnittlichen Partikeldurchmesser (D50) von 3 bis 30 $\mu$m aufweist.

7. Wellenlängenumwandlungselement nach Anspruch 1, wobei der Gehalt des kugelförmigen Siliciumdioxidfüllstoffpulvers 0,5 bis 50 Gewichts-% basierend auf dem Gesamtgewicht der Glasmatrix, des kugelförmigen Siliciumdioxidfüllstoffpulvers und des Phosphorpulvers ist.

8. Wellenlängenumwandlungselement nach Anspruch 1, wobei das Gewichtsverhältnis des Phosphorpulvers und des kugelförmigen Siliciumdioxidfüllstoffpulvers 1:0,1 bis 5 ist.

9. Wellenlängenumwandlungselement nach Anspruch 1, wobei die Glasmatrix aus Glaspulver mit einem durchschnittlichen Partikeldurchmesser (D50) von 2 bis 15 $\mu$m stammt, und

   das Glaspulver die folgende Zusammensetzung basierend auf der Mol-Gesamtzahl des Glaspulvers aufweist:

   2 bis 10 Mol-% $P_2O_5$,
   30 bis 50 Mol-% $ZnO$,
   10 bis 25 Mol-% $SiO_2$, und
   15 bis 25 Mol-% $B_2O_3$.

10. Wellenlängenumwandlungselement nach Anspruch 9, wobei das Glaspulver ferner zumindest eines ausgewählt aus den folgenden Komponenten umfasst:

    1 bis 10 Mol-% $Al_2O_3$,

0,1 bis 7 Mol-% $SnO_2$,
1 bis 5 Mol-% BaO,
0,1 bis 5 Mol-% SrO,
1 bis 5 Mol-% CaO,
1 bis 5 Mol-% $Li_2O$,
1 bis 7 Mol-% $Na_2O$, und
1 bis 5 Mol-% $K_2O$.

11. Verfahren zum Herstellen des Wellenlängenumwandlungselements nach Anspruch 1, das Folgendes umfasst:

einen ersten Schritt des Erhaltens einer Zusammensetzung für ein Wellenlängenumwandlungselement, das Glaspulver, Phosphorpulver und kugelförmiges Siliciumdioxidfüllstoffpulver umfasst;
einen zweiten Schritt des Aufbringens der Zusammensetzung für ein Wellenlängenumwandlungselement auf ein Substrat, um eine grüne Folie für ein Wellenlängenumwandlungselement zu erhalten; und
einen dritten Schritt des Sinterns der grünen Folie für ein Wellenlängenumwandlungselement.

12. Lichtemittierendes Gerät, welches das Wellenlängenumwandlungselement nach einem der Ansprüche 1 bis 10; und eine Lichtquelle, die Anregungslicht auf das Wellenlängenumwandlungselement abstrahlt, umfasst.

## Revendications

1. Élément de conversion de longueur d'onde, qui comprend une matrice de verre ; et une poudre de phosphore et une poudre de charge de silice sphérique dispersées dans la matrice de verre,
dans lequel, lorsque les tailles de particules représentant 10 %, 50 % et 90 % du volume cumulé (%) dans une distribution granulométrique mesurée par diffraction laser sont D10, D50 et D90, respectivement, D50 de la poudre de charge de silice sphérique est de 1,0 à 15,0 $\mu$m, et la valeur SPAN de l'Équation 1 suivante est de 1,0 à 5,0 :

[Équation 1]

$$Span = (D90 - D10)/D50.$$

2. Élément de conversion de longueur d'onde selon la revendication 1, dans lequel la poudre de charge de silice sphérique présente un D90/D10 de 1,5 à 15.

3. Élément de conversion de longueur d'onde selon la revendication 1, dans lequel la poudre de charge de silice sphérique a une surface spécifique (Brunauer-Emmett-Teller ; BET) de 1,0 à 6,5 $m^2$/g.

4. Élément de conversion de longueur d'onde selon la revendication 1, dans lequel la différence d'indice de réfraction entre la matrice de verre et la poudre de charge de silice sphérique est de 0,01 à 0,52.

5. Élément de conversion de longueur d'onde selon la revendication 4, dans lequel la matrice de verre a un indice de réfraction de 1,44 à 1,89 et un point de ramollissement (Ts) de 550 à 850° C.

6. Élément de conversion de longueur d'onde selon la revendication 1, dans lequel la poudre de phosphore a un diamètre moyen de particules (D50) de 3 à 30 $\mu$m.

7. Élément de conversion de longueur d'onde selon la revendication 1, dans lequel la teneur en poudre de charge de silice sphérique est de 0,5 à 50 % en poids sur la base du poids total de la matrice de verre, de la poudre de charge de silice sphérique et de la poudre de phosphore.

8. Élément de conversion de longueur d'onde selon la revendication 1, dans lequel le rapport pondéral de la poudre de phosphore et de la poudre de charge de silice sphérique est de 1:0,1 à 5.

9. Élément de conversion de longueur d'onde selon la revendication 1, dans lequel la matrice de verre est dérivée de poudre de verre ayant un diamètre moyen de particules (D50) de 2 à 15 $\mu$m, et

la poudre de verre a la composition suivante sur la base du nombre total de moles de la poudre de verre :

2 à 10 % en mole de $P_2O_5$,
30 à 50 % en mole de ZnO,
10 à 25 % en mole de $SiO_2$, et
15 à 25 % en mole de $B_2O_3$.

10. Élément de conversion de longueur d'onde selon la revendication 9, dans lequel la poudre de verre comprend en outre au moins l'un choisi parmi les composants suivants :

1 à 10 % en mole d'$Al_2O_3$,
0,1 à 7 % en mole de $SnO_2$,
1 à 5 % en mole de BaO,
0,1 à 5 % en mole de SrO,
1 à 5 % en mole de CaO,
1 à 5 % en moles de $Li_2O$,
1 à 7 % en mole de $Na_2O$, et
1 à 5 % en mole de $K_2O$.

11. Procédé de préparation de l'élément de conversion de longueur d'onde selon la revendication 1, qui comprend :

une première étape d'obtention d'une composition pour un élément de conversion de longueur d'onde comprenant une poudre de verre, une poudre de phosphore et une poudre de charge de silice sphérique ;
une deuxième étape d'application de la composition pour un élément de conversion de longueur d'onde sur un substrat pour obtenir une feuille verte pour un élément de conversion de longueur d'onde ; et
une troisième étape de frittage de la feuille verte pour un élément de conversion de longueur d'onde.

12. Dispositif électroluminescent, qui comprend l'élément de conversion de longueur d'onde selon l'une quelconque des revendications 1 à 10 ; et une source de lumière qui irradie de la lumière d'excitation vers l'élément de conversion de longueur d'onde.

EP 4 339 661 B1

[Fig. 1]

100

120    130

110

[Fig. 2]

130

Lmax

Lmin

19

[Fig. 3]

<u>S100</u>

S110

Preparing a composition for a wavelength conversion member

S120

Applying the composition for a wavelength conversion member to obtain a green sheet for a wavelength conversion member

S130

Sintering the green sheet for a wavelength conversion member

Wavelength conversion member

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003258308 A

- JP 4895541 B